# EUROPEAN PATENT APPLICATION

(11) **EP 2 402 773 A2**
(43) Date of publication of application: **04.01.2012**
(21) Application number: 11005307.1
(22) Date of filing: 29.06.2011
(51) Int. Cl.: G01R 31/02

(54) **Power supply device capable of detecting disconnection of ground line**

(30) Priority: 30.06.2010 JP 2010150565
(71) Applicant: Sanyo Electric Co., Ltd., Osaka 570-8677 (JP)
(72) Inventor: HASHIMOTO, Masahiko, Moriguchi-shi Osaka 570-8677 (JP); NISHIMURA, Masato, Moriguchi-shi Osaka 570-8677 (JP)
(74) Representative: Hertz, Oliver

(57) **Abstract**

A power supply device includes negative-side and positive-side battery blocks serially connected to each other through a resistor element 19. The ends of the element 19 correspond to reference and auxiliary ground points 8A and 8B. A voltage detector 3 detects the voltages of battery modules 2 of a load-driving battery 1. The detector 3 includes an asymmetric resistor circuit that is asymmetrically constructed with respect to the reference point 8A. The detector 3 detects the voltage of the auxiliary point 8B with respect to the reference point 8A in a load driven state. A disconnection detecting circuit 20 compares the detected voltage with a reference voltage of the auxiliary point 8B with respect to the reference point 8A not in the load driven state, and determines that the line 9 is disconnected in the load driven state if the deviation of the detected voltage from the reference voltage falls out of a predetermined range.

## Description

### BACKGROUND OF THE INVENTION

### 1. Field of the Invention

The present invention relates to a power supply device that powers an electric motor to drive an electric vehicle such as hybrid car and electric vehicle, for example, and in particular to a power supply device that includes a voltage detecting circuit for detecting the voltages of battery modules serially connected to each other.

### 2. Description of the Related Art

Power supply devices for powering an electric vehicle are required to include a high voltage battery to increase the output of the power supply devices. The reason is that output is proportional to the product of voltage and current of the battery. For example, the battery of a power supply device for powering a hybrid or electric car has very high voltage of 200 V or more. High voltage batteries include battery modules each of which includes a plurality of rechargeable battery cells serially connected to each other. Also, the battery modules are serially connected to each other. Thus, the output of the batteries can be high.

For this reason, in the battery that includes a number of battery modules serially connected to each other, it is important to prevent the battery modules from being over-charged and over-discharged when the battery modules are charged/discharged. The reason is that, if being over-charged/over-discharged, battery cells deteriorate in electrical performance and additionally in battery life. In order to prevent the battery modules from being over-charged/over-discharged, vehicle power supply devices include a voltage detecting circuit that detects the voltages of the battery modules.

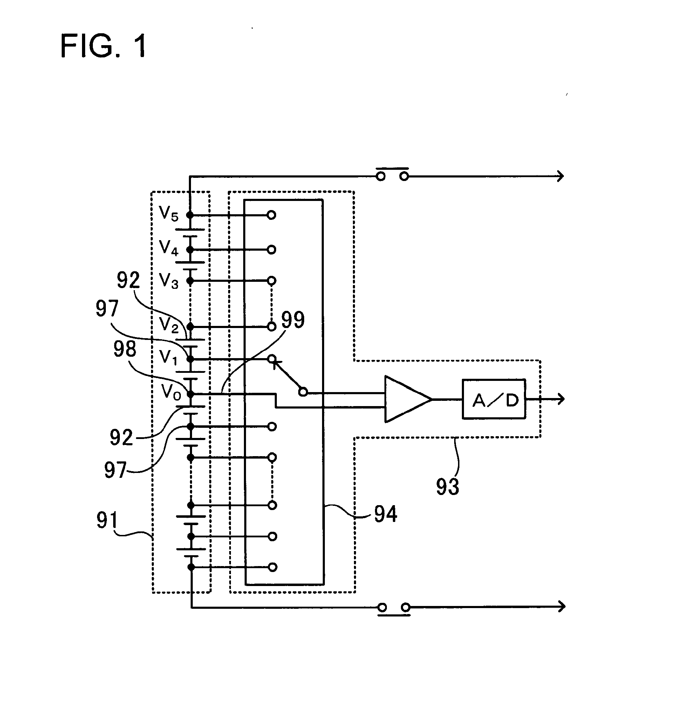

As shown in Fig. 1, a voltage detecting circuit 93 detects the voltages at nodes 97 with respect to a reference point 98 corresponding to the mid-voltage point among battery modules 92, and calculates the voltages of the battery modules. This voltage detecting circuit 93 detects the voltages of the battery modules 92 based on the difference between the voltages at the nodes 97 corresponding to the battery modules 92. Since the voltage detecting circuit 93 detects the voltages at the nodes 97 corresponding to the battery modules 92 with respect to the reference point 98, all of the detection voltages are detected as voltages with respect to the reference point 98. Thus, as illustrated, the voltages at the nodes 97 can be detected by using a multiplexer 94 that switches the nodes 97 corresponding to the battery modules 92 one to another.

However, this voltage detecting circuit 93 detects all of the voltage based on voltages with respect to the reference point 98. If a ground line 99 is disconnected which connects the reference point 98 to the voltage detecting circuit 93, the voltages of the battery modules 92 cannot be properly detected. The ground line 99 is composed of connectors and connecting cords, terminals and connecting cord, or the like, for connecting the reference point 98 of the battery 91 to the voltage detecting circuit 93. Metal surfaces of the connector or terminals are in press contact with each other for electrical connection. It is impossible to completely eliminate the deterioration effects of time on metal surfaces. If a metal surface is deteriorated, the deteriorated metal surface may cause improper electrical connection. In particular, vehicles are used in severe external environments in terms of temperature, humidity, dust, and the like. For this reason, in vehicle use, it is impossible to completely eliminate the deterioration effects on the connector or terminals. Improper electrical connection of the connector or terminals in the ground line increase or vary the electrical resistance of a connection part, which in turn makes the voltage of the reference point unstable or results in variation of the voltage of the reference point. On the other hand, if the connecting cord is disconnected, the voltage of the reference point cannot be detected. In the case where the vehicle power supply device cannot properly detect the voltages of the battery modules, the battery may be over-charged/over-discharged and be remarkably deteriorated. In this case, even if the battery can be charged/discharged, the charging/discharging operation of the battery will be limited or prohibited, which in turn disables proper vehicle traveling by the battery power.

To solve the problem, a vehicle power supply device has been developed which includes a circuit for detecting disconnection of the ground line.

See Japanese Patent Laid-Open Publication No. JP 2008-34296 A, for example.

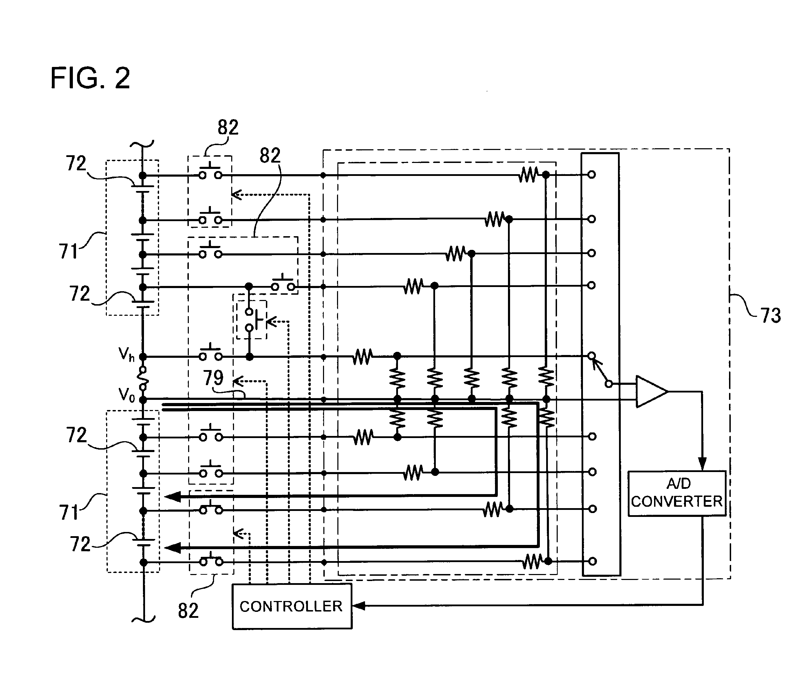

Fig. 2 shows the power supply device disclosed in Japanese Laid-Open Publication No. 2008-86069. This power supply device controls ON/OFF switching of detection switches 82 connected to the input side of a voltage detecting circuit 73 to detects disconnection of a ground line 79 in standby time where a vehicle is not driven after an ignition switch as vehicle main switch is turned ON. Accordingly, this power supply device cannot detect disconnection of the ground line 79 when the vehicle is driven. The reason is that, when the power supply device powers the vehicle, all of the detection switches 82 are held ON to detect the voltages of the battery modules 72 in order to prevent that driving batteries 71 are over-charged/over-discharged. Accordingly, this power supply device cannot detect disconnection of the ground line 79 when the vehicle is driven. The ground line 79 may be disconnected by vibration or the like when the vehicle is driven. However, the known vehicle power supply device cannot detect disconnection of the ground line 79 when the vehicle is driven. If the ground line 79 is disconnected when the vehicle is driven, the voltages of the battery modules 72 cannot be properly detected which compose the driving battery 71. Charging/discharging operation of the driving battery 71 is controlled with the voltages of the battery modules 72 being detected for preventing that the battery modules 72 are over-charged/over-discharged. In the case where the voltages of the battery modules 72 cannot be properly detected, it is impossible to surely protect the batteries 71 from being over-charged/over-discharged. In this case, the driving batteries 71 cannot be properly charged/discharged.

The present invention has been developed for solving the disadvantages. It is an object of the present invention to provide a power supply device that can detect disconnection of a ground line by using a simple circuit even when a vehicle is driven, and can determine whether the voltages of battery modules are properly detected whereby charging/discharging the battery modules with protection of the battery modules from being over-charged/over-discharged.

### SUMMARY OF THE INVENTION

A power supply device according to the present invention includes a driving battery 1, a voltage detecting circuit 3, a ground line 9, an asymmetric voltage dividing resistor circuit 11, and a disconnection detecting circuit 20. The driving battery 1 includes positive-side and negative-side battery blocks 1A and 1 B. The positive-side and negative-side battery blocks 1A and 1 B are serially connected to each other through a resistor element 19. The voltage detecting circuit 3 detects the voltages of battery modules 2. The battery modules 2 are serially connected to each other, and compose the driving battery 1. The ground line 9 connects one of input terminals of the voltage detecting circuit 3 to a reference ground point 8A of the driving battery 1. The asymmetric voltage dividing resistor circuit 11 is connected to other input terminals of the voltage detecting circuit 3. The asymmetric voltage dividing resistor circuit is asymmetrically constructed with respect to the reference ground point 8A. The disconnection detecting circuit 20 detects disconnection of the ground line 9. A node serves as the reference ground point 8A between one end of the resistor element 19 and one of the battery blocks of the driving battery 1. A node serves as an auxiliary ground point 8B between the other end of the resistor element 19 and the other of the battery blocks of the driving battery 1. The voltage detecting circuit 3 detects the voltage of the auxiliary ground point 8B with respect to the reference ground point 8A with the auxiliary ground point 8B being connected to the voltage detecting circuit 3 through the voltage dividing resistor circuit 11. The voltage detecting circuit 3 detects the voltage of the auxiliary ground point 8B as a vehicle traveling voltage with respect to the reference ground point 8A in vehicle traveling. The disconnection detecting circuit 20 compares the detected vehicle traveling voltage with a reference voltage of the auxiliary ground point 8B with respect to the reference ground point 8A not in vehicle traveling, and determines that the ground line 9 is disconnected in vehicle traveling if the deviation of the detected vehicle traveling voltage from the reference voltage falls out of a predetermined voltage range.

The power supply device can detect disconnection of a ground line by using a simple circuit even when a vehicle is driven, and can determine whether the voltages of battery modules are properly detected whereby charging/discharging the battery modules with protection of the battery modules from being over-charged/over-discharged.

In the power supply device, the resistor element 19 can be a fuse 19A, a current detecting resistor, or a series circuit composed of fuse and current detecting resistor.

In the power supply device, the reference voltage is obtained by detecting a resistor element voltage not in vehicle traveling by the voltage detecting circuit 3, or a resistor element voltage not in vehicle traveling is previously stored as the reference voltage in the memory 21.

In the power supply device, the reference voltage is obtained by detecting the resistor element voltage by the voltage detecting circuit 3 in standby time where the driving battery 1 is not charged/discharged after an ignition switch as vehicle main switch is turned ON.

In the power supply device, the voltage detecting circuit 3 is a circuit for detecting the voltages of battery modules 2, which compose the driving battery 1.
The above and further objects of the present invention as well as the features thereof will become more apparent from the following detailed description to be made in conjunction with the accompanying drawings.

### BRIEF DESCRIPTION OF THE DRAWINGS

Fig. 1 is a circuit diagram showing a voltage detecting circuit in a conventional power supply device;
Fig. 2 is a schematic view showing a vehicle power supply device according to a patent application, which has been filed by the applicant;
Fig. 3 is a schematic view showing a vehicle power supply device according to an embodiment of the present invention;
Fig. 4 is a diagram showing the operating principle of the vehicle power supply device shown in Fig. 3 for detecting disconnection of a ground line in standby time;
Fig. 5 is a diagram showing the operating principle of the vehicle power supply device shown in Fig. 3 for detecting disconnection of a ground line in standby time;
Fig. 6 is a diagram showing the operating principle of the vehicle power supply device shown in Fig. 3 for detecting disconnection of a ground line in standby time;
Fig. 7 is a diagram showing the operating principle of the vehicle power supply device shown in Fig. 3 for detecting disconnection of a resistor element in standby time;
Fig. 8 is a diagram showing the operating principle of the vehicle power supply device shown in Fig. 3 for detecting disconnection of a resistor element in standby time;
Fig. 9 is a diagram showing the operating principle of the vehicle power supply device shown in Fig. 3 for detecting disconnection of a ground line and a resistor element in standby time;
Fig. 10 is a diagram showing the operating principle of the vehicle power supply device shown in Fig. 3 for detecting disconnection of a resistor element voltage detection line in standby time;
Fig. 11 is a diagram showing the operating principle of the vehicle power supply device shown in Fig. 3 for detecting disconnection of a resistor element voltage detection line in standby time;
Fig. 12 is a diagram showing the operating principle of the vehicle power supply device shown in Fig. 3 for detecting disconnection of a resistor element voltage detection line in standby time;
Fig. 13 is a diagram showing the operating principle of the vehicle power supply device shown in Fig. 3 for detecting disconnection of a resistor element voltage detection line in standby time;
Fig. 14 is a diagram showing the operating principle of the vehicle power supply device shown in Fig. 3 for detecting disconnection of a ground line in vehicle traveling; and
Fig. 15 is a block diagram a power storage type power supply device to which the present invention is applied.

### DETAILED DESCRIPTION OF THE EMBODIMENT(S)

The following description will describe embodiments according to the present invention with reference to the drawings.

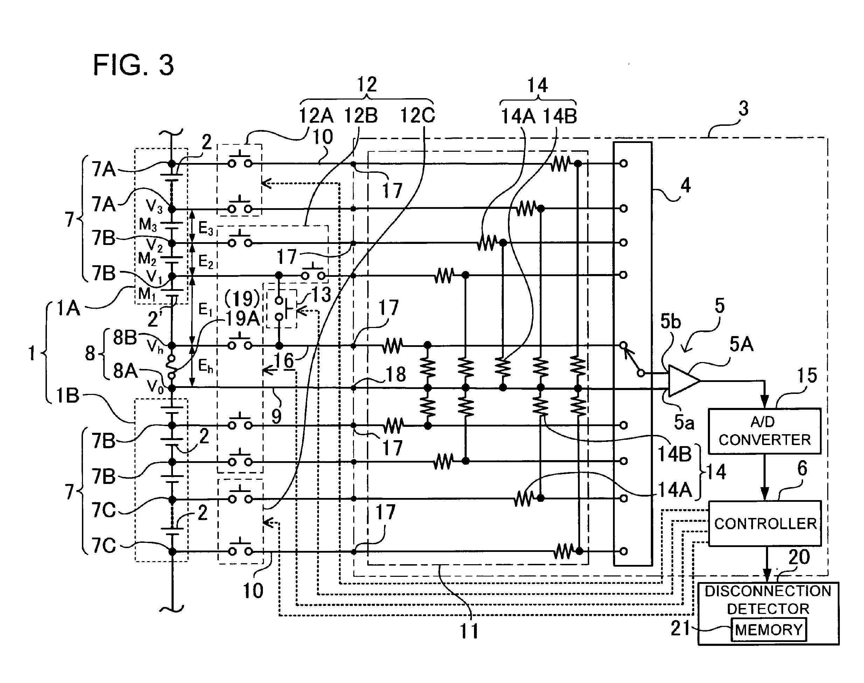

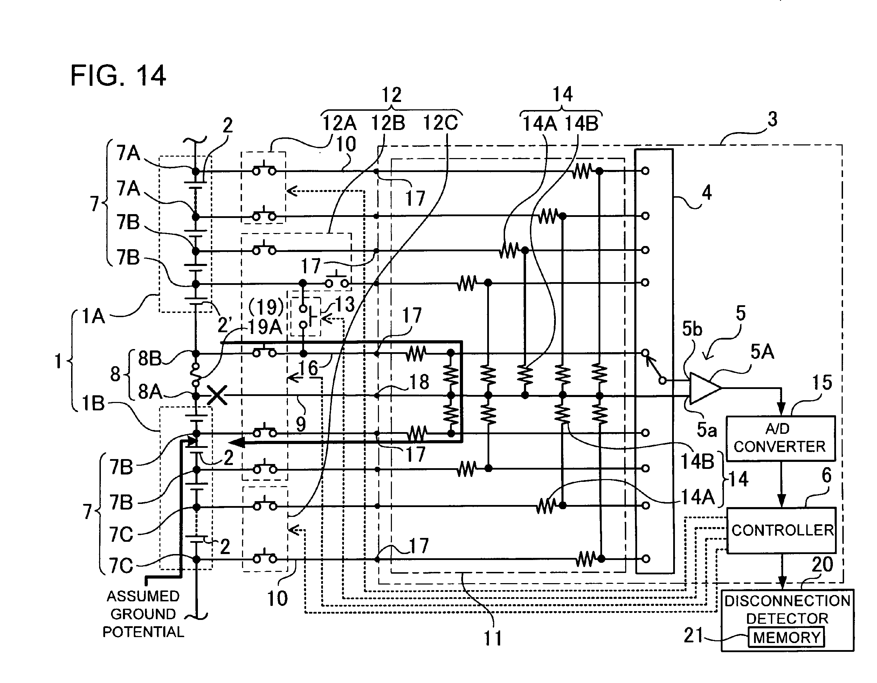

A power supply device shown in Figs. 3 to 14 includes a driving battery 1, a voltage detecting circuit 3, a ground line 9, and a disconnection detecting circuit 20. The driving battery 1 includes positive-side and negative-side battery blocks 1A and 1 B. The positive-side battery and negative-side battery blocks 1A and 1 B are serially connected to each other through a resistor element 19. The resistor element 19 is composed of a fuse 19A, a current detecting resistor, a series circuit of fuse and current detecting resistor, or the like. The voltage detecting circuit 3 detects the voltages of battery modules 2. The battery modules 2 are serially connected to each other, and compose the driving battery 1. The ground line 9 connects one of input terminals of the voltage detecting circuit 3 to a reference ground point 8A of the driving battery 1. The disconnection detecting circuit 20 detects disconnection of the ground line 9 in vehicle traveling.

The vehicle power supply device detects disconnection of the ground line 9 in standby time where an ignition switch is turned ON and also in vehicle traveling time where a vehicle is driven.

The driving battery 1 is composed of the positive-side and negative-side battery blocks 1A and 1B serially connected to each other. The resistor element 19 is connected at a connection point between the positive-side and negative-side battery blocks 1A and 1 B in the illustrated driving battery 1.
In this embodiment, the resistor element 19 is the fuse 19A. The resistor element can be a current detecting resistor, which detects the current flowing through the driving battery, or a series circuit composed of the fuse and the current detecting resistor. The fuse 19A as the resistor element 19 is disconnected if an over-current flows through the driving battery 1. Each of the positive-side and negative-side battery blocks 1A and 1 B of the driving battery 1 includes a plurality of battery modules 2. Battery modules 2 composing the positive-side block 1A are serially connected to each other on the positive side with respect to one of mid-connection points 8. Battery modules 2 composing the negative-side block 1 B are serially connected to each other on the negative side with respect to the other of the mid-connection points 8.

In order to charge/discharge the battery modules 2 with prevention of the battery modules 2 from being over-charged/over-discharged, the power supply device includes the voltage detecting circuit 3, which detects the voltages of the battery modules 2. To achieve this, the power supply device detects the voltages at node 7 corresponding to the battery modules 2, and detects the voltages of the battery modules 2. The voltage detecting circuit 3 detects the voltages of all of the nodes 7, and thus can detect the voltages of all of the battery modules 2. However, the voltage detecting circuit does not necessarily detect the voltages of all of the nodes. The voltage detecting circuit may detect the voltages of units each of which is composed of a plurality of serially-connected battery modules by detecting the voltages at nodes between the units. For example, in the case where the battery is composed of 50 serially-connected battery modules, the voltage detecting circuit preferably detects the voltages of all of the 50 battery modules. Alternatively, the voltage detecting circuit may detect the unit voltages of 25 units each of which is composed of two serially-connected battery modules. The unit voltage corresponds to the total voltage of two battery modules.

Based on the detected voltage of the battery module 2, the remaining capacity of the battery module 2 can be calculated. Also, based on the detected voltage of the battery module 2, the remaining capacity of the battery module 2 can be corrected which is calculated by integrating charging/discharging current. Also, based on the detected voltage of the battery module 2, it can be detected that the remaining capacity of the battery module 2 reaches zero, which means that the battery module 2 is completely discharged. If the battery module 2 is completely discharged, the discharging current is cut off. Also, based on the detected voltage of the battery module 2, it can be detected that the battery module 2 is fully charged. If the battery module 2 is fully charged, the charging current is cut off.

The driving battery 1 with a number of the battery modules 2 serially connected to each other is charged/discharged at the same amount of current. Accordingly, the charged/discharged amounts of all of the battery modules will be the same as each other. However, the electrical characteristics of all of the battery modules 2 do not always equally vary. In particular, in the case where the number of repetitive charging/discharging cycles increases, the battery modules 2 deteriorate in different extents. For this reason, the full charge capacities of the battery modules 2 vary in different extents. In this case, the battery module 2 with a reduced full charge capacity becomes likely to be over-charged/over-discharged. If a battery module is overcharged or over-discharged, the electrical characteristics of this battery module sharply deteriorate. In order to prevent sharp battery module deterioration, it is necessary for a battery module with a reduced full charge capacity to be prevented from being over-charged/over-discharged. In the driving battery 1 with a number of the battery modules 2 serially connected to each other, for this reason, it is important to charge/discharge the battery modules 2 with all of the battery modules 2 being prevented from being over-charged/over-discharged, i.e., with the battery modules 2 being protected. In order to charge/discharge the battery modules 2 with all of the battery modules 2 being protected, the voltage detecting circuit 3 detects the voltages of the battery modules 2.

In the illustrated driving power supply device 1 is composed of two divided blocks, which are the positive-side and negative-side battery blocks 1A and 1 B. For example, in the case where the driving battery includes 50 serially-connected battery modules, the driving battery can be composed of two divided blocks, which are the positive-side block composed of 25 battery modules and the negative-side battery block composed of 25 battery modules. Alternatively, the driving battery can be composed of two divided blocks, which are the positive-side block composed of 24 battery modules and the negative-side battery block composed of 26 battery modules, so that the driving battery totally includes 50 serially-connected battery modules. The voltage detecting circuit 3 detects the voltages of the battery modules 2 of both the battery blocks.

Each of the battery modules 2 includes five nickel-hydrogen battery cells, which are serially connected to each other. For example, the driving battery 1 totally includes 250 nickel-hydrogen battery cells, which are serially connected to each other, and provides output voltage of 300 V. The battery module 2 is not limited to include five battery cells, but can include four or less, or six or more of rechargeable battery cells that are serially connected to each other. The driving battery is not limited to include 50 battery modules that are serially connected to each other, but can include less than, or more than 50 battery modules that are serially connected to each other. The rechargeable battery cell of the battery module can be other type rechargeable battery cells such as lithium-ion rechargeable battery cell and nickel-cadmium battery cell.
In the case of the power supply device is composed of lithium-ion rechargeable battery cells as the rechargeable battery cells of the battery modules, the battery module can be composed of one lithium-ion rechargeable battery cell.

In the case where the driving battery 1 is composed of two divided blocks, which are the positive-side and negative-side battery block 1A and 1 B, when the power supply device detects the voltages of the battery modules by using one voltage detecting circuit 3, the voltages ate the nodes 7 are detected by selecting the node 7 corresponding to the battery modules 2 one after another by using a multiplexer 4.

The positive and negative sides of the resistor element 19 are connected the battery blocks in the illustrated driving battery 1. Each of the battery blocks is connected to the resistor element 19 at the mid-connection point 8. A node between one end of the resistor element 19 and one of the battery blocks is a reference ground point 8A. A node between the other end of the resistor element 19 and the other battery block is an auxiliary ground point 8B. In the illustrated power supply device, the node between the resistor element 19 and the negative-side battery block 1 B is the reference ground point 8A. The node between the resistor element 19 and the positive-side battery block 1A is the auxiliary ground point 8B. The battery modules 2 of the positive-side and negative-side battery blocks 1A and 1B are serially connected to each other through the mid-connection points 8.

The voltage detecting circuit 3 detects the voltages at the nodes 7 with respect to the reference ground point 8A, and calculates the voltages of the battery modules 2 based on the detected voltage difference between the nodes 7. The reference ground point 8A is connected to a reference input terminal 18 of the voltage detecting circuit 3 by the ground line 9. The ground line 9 is a lead line. One end of the ground line 9 is connected to the reference ground point 8A of the driving battery 1 through terminals or connectors. The other end of the ground line 9 is connected to the reference input terminal 18 of the voltage detecting circuit 3. The ground line 9 serves as an earth line of the voltage detecting circuit 3. However, the ground line 9 as the earth line of the voltage detecting circuit 3 is not connected to the vehicle chassis ground. The reason is to prevent electric shocks.

The nodes 7 corresponding to the battery modules 2 are voltage detection points, and are connected to voltage input terminals 17 of the voltage detecting circuit 3 through detection switches 12 and voltage detection lines 10. The voltage detecting circuit 3 detects the voltages at the nodes 7 with respect to the reference ground point 8A, and calculates the voltages of the battery modules 2.

In the power supply device shown in Figs. 3 to 14, the auxiliary ground point 8B is connected to the voltage input terminal 17 of the voltage detecting circuit 3 through a resistor element voltage detection line 16. A detection switch 12 is also connected at a point on the resistor element voltage detection line 16. The voltage drop of the resistor element 19 can be detected through the resistor element voltage detection line 16. In other words, the voltage detecting circuit 3 is provided with the voltages of the reference ground point 8A and the auxiliary ground point 8B, and detects the voltage drop of the resistor element 19.

An asymmetric voltage dividing resistor circuit 11 is connected to the input side of the voltage detecting circuit 3. The illustrated voltage detecting circuit 3 includes a voltage dividing resistor circuit 11, the multiplexer 4, and a voltage detecting portion 5. The voltage dividing resistor circuit 11 obtains fractions of the voltages at the nodes 7 between battery modules 2, and a fraction of the voltage of the auxiliary ground point 8B. The multiplexer 4 selects the fractions of the voltages obtained by the voltage dividing resistor circuit 11 one after another in a time-division manner. The voltage detecting portion 5 is connected to the output side of the multiplexer 4.

The voltage dividing resistor circuit 11 includes two serially-connected resistors 14 corresponding to each of the nodes 7 and the auxiliary ground point 8B. The multiplexer 4 is provided with the thus-obtained fractions of the voltages at the nodes 7 and the auxiliary ground point 8B. Since the voltage dividing resistor circuit 11 is asymmetrical with respect to the reference ground point 8A, the node between the negative-side battery block 1 B and the resistor element 19 serves as the reference ground point 8A in the voltage dividing resistor circuit 11 shown in Fig. 3. The positive side of the reference ground point 8A is connected to a voltage dividing circuit part that obtains the fraction of the voltage of the auxiliary ground point 8B so that the voltage dividing resistor circuit 11 is asymmetrical with respect to the reference ground point 8A. It is noted that the resistances of the resistors connected on the positive side with respect to the reference ground point can be set different from the resistances of the resistors connected on the negative side with respect to the reference ground point so that the voltage dividing resistor circuit is asymmetrical with respect to the reference ground point. Also, the voltage of the positive-side battery block can be set different from the voltage of the negative-side battery block so that the voltage dividing resistor circuit is asymmetrical with respect to the reference ground point. In this specification, the asymmetrical voltage dividing resistor circuit is not limited to the circuit shown in Fig. 3.

The obtained fractions of the voltages at the nodes 7 and the auxiliary ground point 8B in the voltage dividing resistor circuit 11 are set so that the maximum voltage among the voltages at the nodes 7 and the auxiliary ground point 8B does not exceed the maximum rated voltage of the multiplexer 4. The voltage dividing resistor circuit 11 obtains a specified fraction of the voltage at each of the nodes 7 and the auxiliary ground point 8B. The fraction obtained by the voltage dividing resistor circuit 11 is specified by the electrical resistances of the serially-connected resistors 14. In the case where the electrical resistance of a series resistor 14A is set larger as compared with a parallel resistor 14B, the fraction obtained by the voltage dividing resistor circuit 11 can be small, in other words, the input voltage provided to the multiplexer 4 can be low. The series resistor 14A is serially connected to the input of the multiplexer 4, while the parallel resistor 14B is connected to the input of the multiplexer 4 in parallel.

The voltage dividing resistor circuit 11 preferably provides the multiplexer 4 with several V, which is obtained as fractions of the voltages at the nodes 7 and the auxiliary ground point 8B. The fraction obtained by the voltage dividing resistor circuit 11 is determined by the resistance ratio of the resistors. As discussed later, the thus-detected fractions of the voltages are provide to a control circuit 6 through the voltage detecting portion 5 and an A/D converter 15 so that the control circuit 6 calculates the actual voltages at the nodes and the auxiliary ground point in consideration of the fraction of the voltage dividing resistor circuit 11, and calculates the voltages of the battery modules. For example, in the case where the fraction obtained by the voltage dividing resistor circuit 11 is 1/50, the voltage detecting circuit 3 can obtain the actual voltages at the nodes 7 and the auxiliary ground point 8B by multiplying the detected fractions by 50.

The voltage dividing resistor circuit 11 is connected to the nodes 7 and the auxiliary ground point 8B. That is, the fractions of the voltages at the nodes 7 and voltage of the auxiliary ground point 8B are obtained by the voltage dividing resistor circuit 11, and are then provided to the multiplexer 4. The fractions of voltages obtained by the voltage dividing resistor circuit 11 are set to values so that the obtained fractions of voltages as input voltages provided to the multiplexer 4 are substantially the same level as each other.

The detection switches 12 are connected at points on the voltage detection lines 10. In order to detect disconnection of the ground line 9 and the resistor element 19, the detection switches 12 are switched ON/OFF in standby time right after an ignition switch is turned ON. After that, the detection switches 12 are held ON in vehicle traveling. Disconnection of the ground line 9 is detected also in vehicle traveling with the detection switches 12 being held ON. For this reason, in the case where the vehicle power supply device detects disconnection of the ground line only in vehicle traveling, the vehicle power supply device does not necessarily include the detection switches.

The nodes 7 are connected to the voltage input terminals 17 of the voltage detecting circuit 3 through the detection switches 12 and the voltage detection lines 10. The control circuit 6 controls ON/OFF of the detection switches 12, and detects disconnection of the ground line 9 and the resistor element 19 in standby time. After that, with all of the detection switches 12 being held ON, the voltage detecting circuit 3 detects the voltages at the nodes 7 one after another. The voltages of the battery modules 2 are calculated based the detected voltages. Also, the disconnection detecting circuit 20 detects disconnection of the ground line 9 based on the detected voltages.

In the power supply device, the detection switches 12 are connected at points on the voltage detection lines 10. In the case of the power supply device in which the detection switches 12 are connected to all of the voltage detection lines 10, all of the detection switches 12 are turned OFF, so that discharging current can be cut off which flows through the voltage dividing resistor circuit 11 of the driving battery when the vehicle is not in use. Accordingly, in this power supply device, the detection switch 12 can serve as current cut-off switch. In other words, the detection switch 12 can serve as a current cut-off switch that can stop discharging operation of the driving battery 1 when the ignition switch is turned OFF.

To detect disconnection of the ground line 9 in standby time, the detection switches 12 are switched ON/OFF which are connected to the nodes 7 of the battery module 2 on the positive and negative sides. Disconnection of the ground line 9 can be detected based of the voltage change at the node 7 in standby time. The control circuit 6 controls ON/OFF switching operation of the detection switches 12. When the ignition switch is turned ON, the control circuit 6 switches the detection switches 12 ON/OFF to detect disconnection of the ground line 9 in standby time. When the ignition switch is turned OFF, the detection switches 12 are turned OFF so that discharging current through the driving battery 1 is cut off.

In the power supply device of Figs. 3 to 13, the detection switches 12 are grouped into three switch blocks composed of first, second and third switch blocks 12A, 12B, and 12C. The nodes 7 in the battery blocks are also grouped into three blocks. The nodes 7 in the positive-side battery block 1A are grouped into a group of first nodes 7A on the output terminal side and a group of second nodes 7B on the resistor element 19 side. The nodes 7 in the negative-side battery block 1 B are grouped into a group of third nodes 7C on the output terminal side and the group of second nodes 7B on the resistor element 19 side. The first nodes 7A are connected to the voltage detecting circuit 3 through the detection switches of the first switch block 12A. The second nodes 7B are connected to the voltage detecting circuit 3 through the detection switches of the second switch block 12B. The third nodes 7C are connected to the voltage detecting circuit 3 through the detection switches of the third switch block 12C.

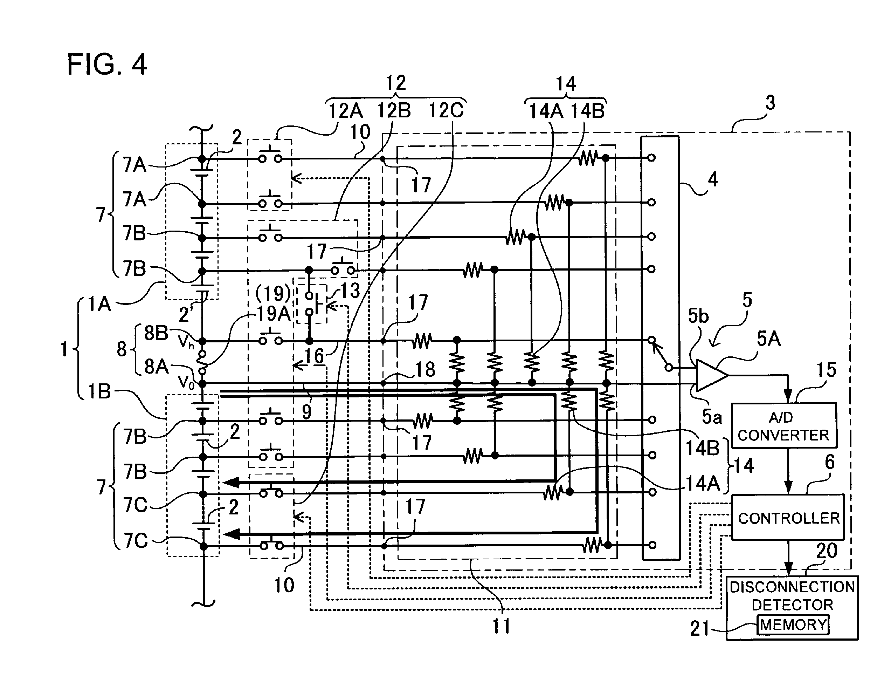

In this power supply device, as shown in Fig. 4, the detection switches of the second switch block 12B are switched ON/OFF with the detection switches of the third switch block 12C being held ON so that disconnection of the ground line 9 can be detected in standby time based on the voltage change at the third nodes 7C. Figs. 4 to 6 show the operating principle of this detection. It is noted that, although the illustrated operating principle shows that disconnection of the ground line 9 is detected based on the voltage change at the third nodes 7C, the detection switches of the second switch block 12B may be switched ON/OFF with the detection switches of the first switch block 12A being held ON so that disconnection of the ground line 9 can be detected based on the voltage change at the first nodes 7A.

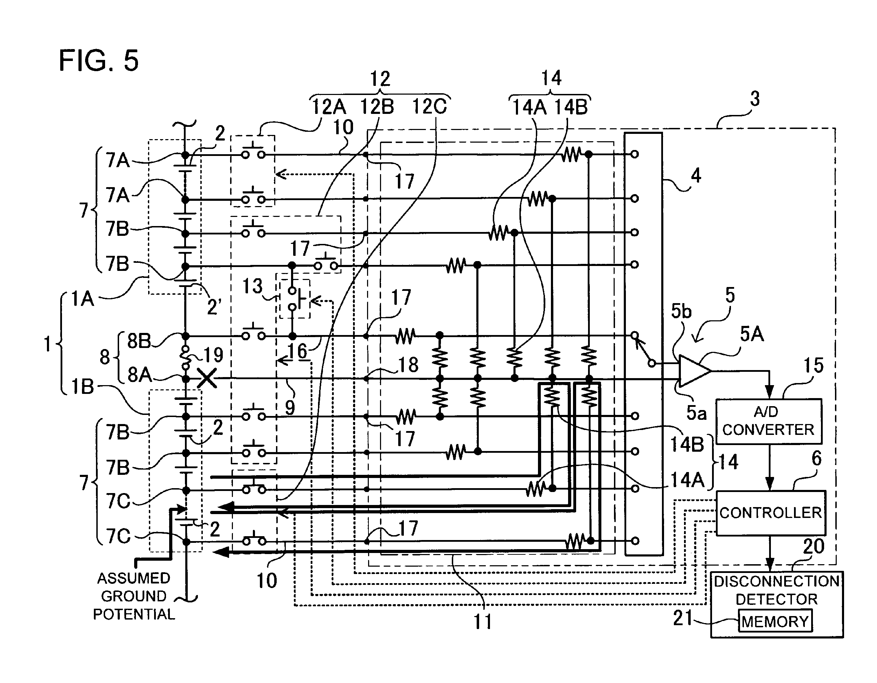

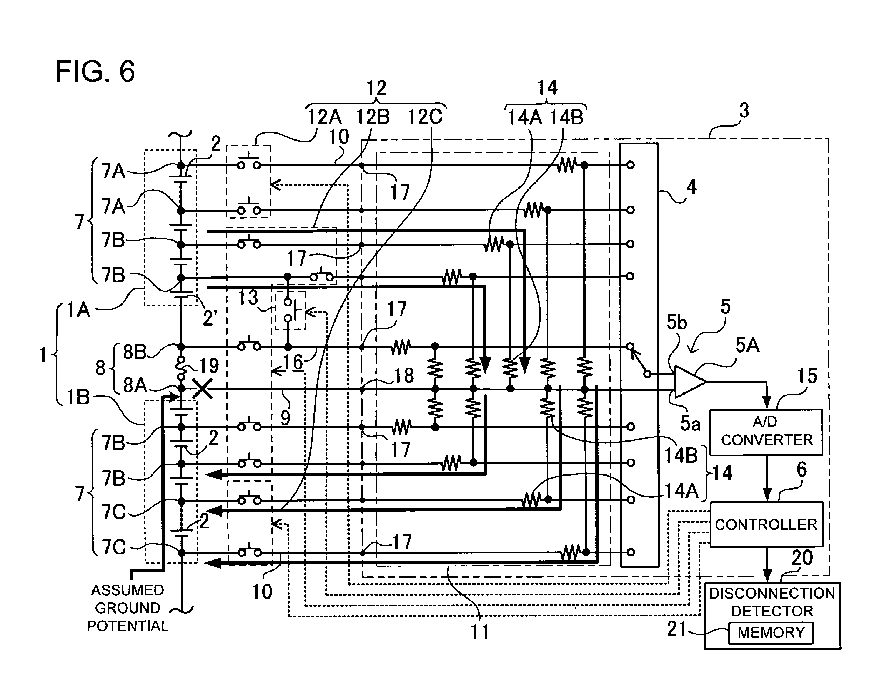

In the case where the ground line 9 is disconnected as shown in Figs. 5 and 6, the reference ground point 8A is connected to the reference input terminal 18 of the voltage detecting circuit 3. In this case, the voltage of the reference input terminal 18 of the voltage detecting circuit 3 is deviated to an assumed ground potential. Since the reference potential of the reference input terminal 18 is deviated, the voltage of the third node 7C or the first node 7A changes which is provided to the voltage input terminal 17. The reason is that the voltage detecting circuit 3 detects the potential difference between the reference input terminal 18 and the voltage input terminal 17.

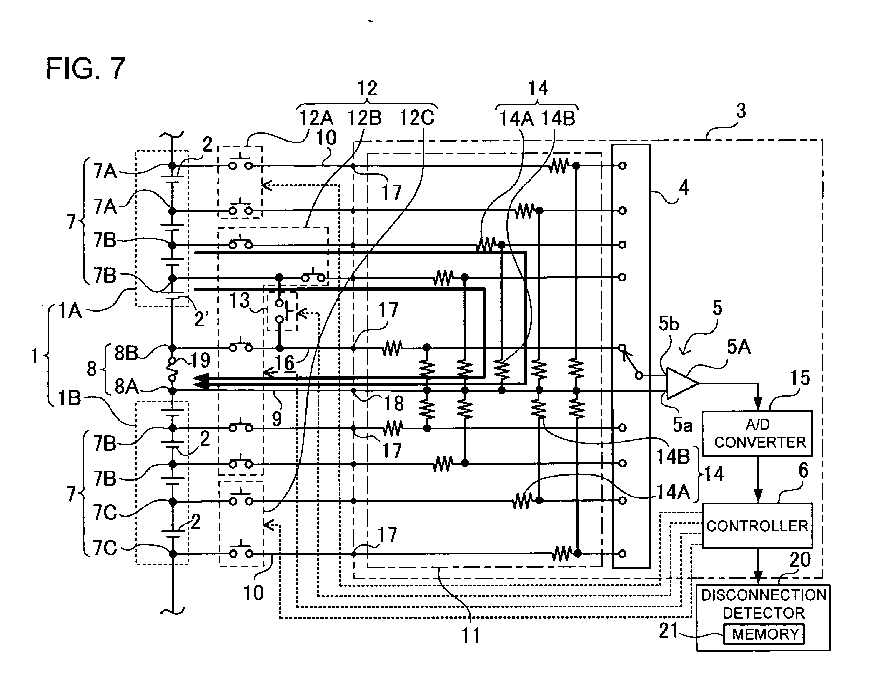

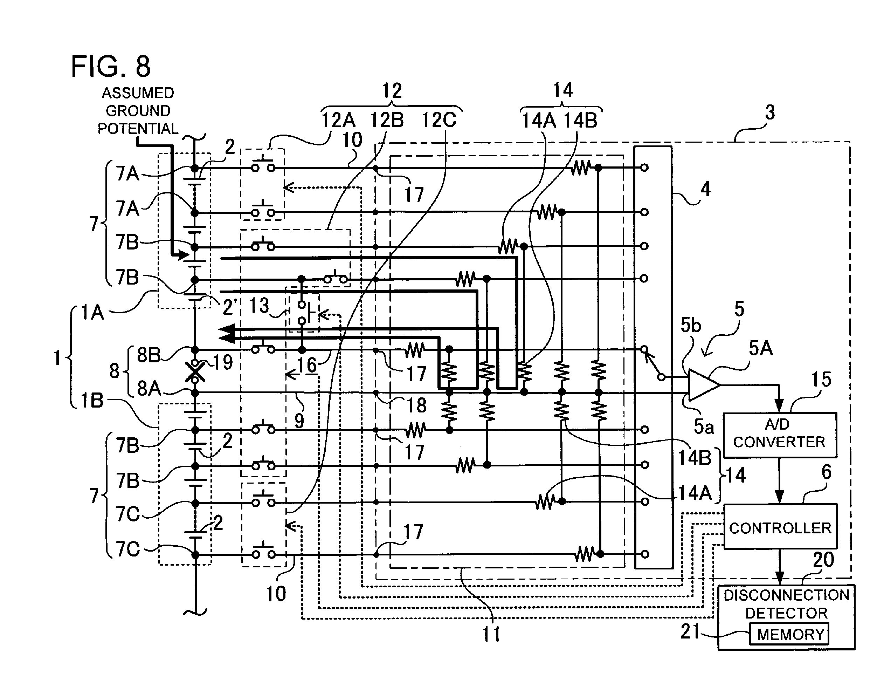

Figs. 7 and 8 show operation for detecting disconnection of the resistor element 19. Disconnection of the resistor element 19 can be detected based on whether the voltage at the second node 7B on the positive-side battery block 1 A is positive or negative when the detection switches of the second switch block 12B are turned to ON. As shown in Fig. 7, in the case where the resistor element 19 is not disconnected, when the detection switches of the second switch block 12B are turned to ON, current flow as shown by the arrows in Fig. 7 so that all of the voltages of all of the second nodes 7B on the positive-side battery block 1A are positive. The reason is that the nodes 7 on the positive-side battery block 1A are connected to the positive side with respect to the ground line 9. Contrary to this, in the case where the resistor element 19 is disconnected, when the second switch block 12B is turned to ON, current flow as shown by the arrows in Fig. 8 so that the assumed ground potential is deviated toward the positive side with respect to the auxiliary ground point 8B. Accordingly, the voltages of nodes among the second nodes 7B become negative which are connected in the positive-side battery block 1A and on the negative side with respect to the assumed ground potential. Thus, disconnection of the resistor element 19 can be detected based on whether the voltages of the second nodes 7B in the positive-side battery block 1A are positive or negative.

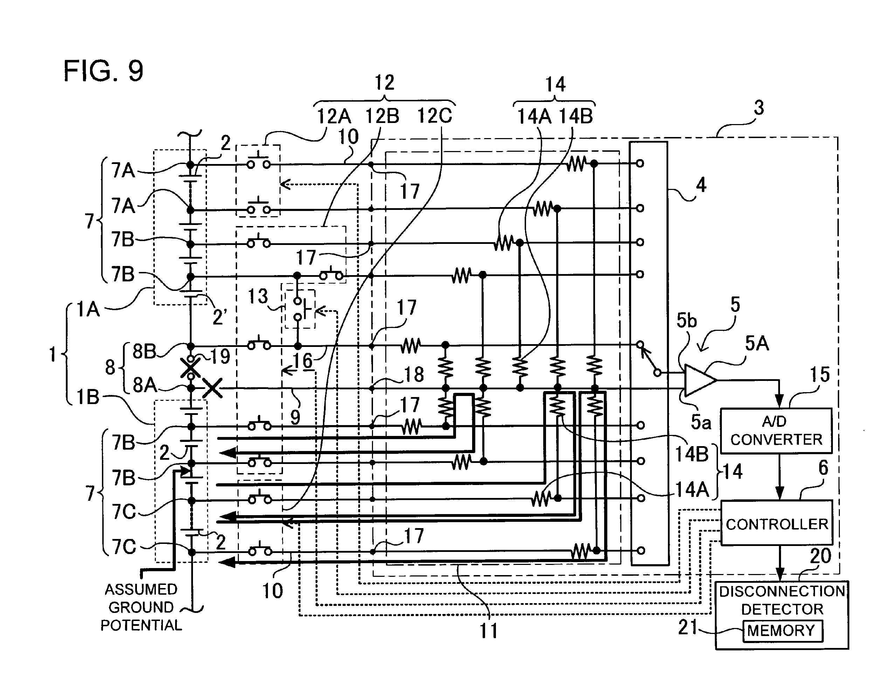

In addition, in the case where both the resistor element 19 and the ground line 9 are disconnected as shown in Fig. 9, the assumed ground potential is deviated. For this reason, disconnection of both the resistor element 19 and the ground line 9 can be detected by detecting the voltage at the second node 7B on the negative-side battery block 1 B when the detection switches of the second switch block 12B are turned to ON.

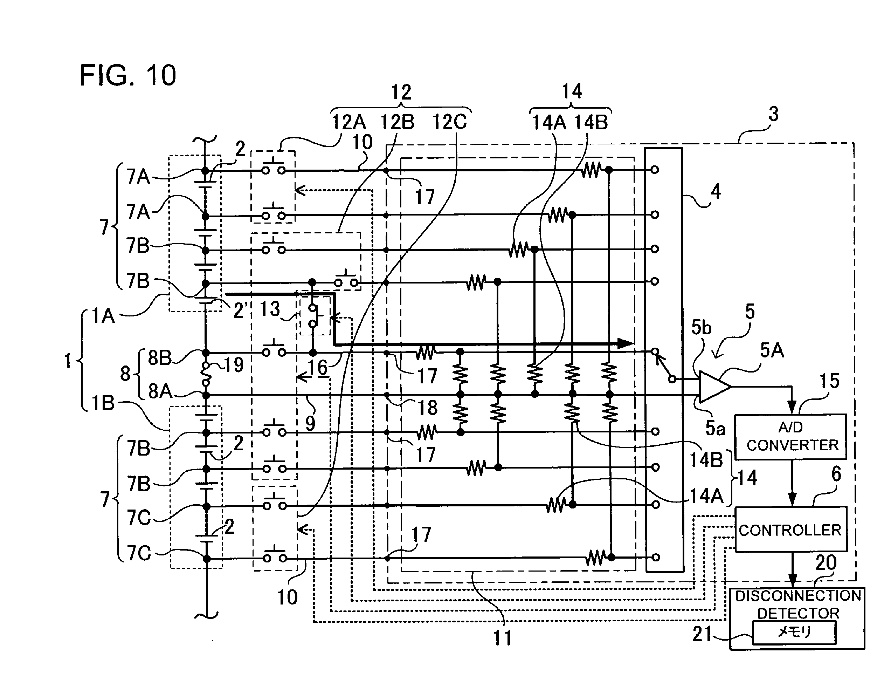

In the power supply device shown in Figs. 3 to 13, the detection switch 12 is connected at a point also on the resistor element voltage detection line 16. The auxiliary ground point 8B is connected to the voltage detecting circuit 3 through one corresponding detection switch of the second switch block 12B. Also, the resistor element voltage detection line 16 is connected to the auxiliary ground point 8B, and is connected to one node 7 in the positive-side battery block 1A through a resistor element switch 13, which can be turned ON/OFF. One end of the resistor element switch 13 is connected to the resistor element voltage detection line 16. The one end of the resistor element switch 13 is connected to a point on the voltage detecting circuit 3 side with respect to the second switch block 12B on the resistor element voltage detection line 16. The other end of the resistor element switch 13 is directly connected to the one node 7 in the positive-side battery block 1A. This power supply device can detect disconnection of the resistor element voltage detection line 16 by selectively turning the detection switches 12 ON as shown in Figs. 10 to 13.

The resistor element voltage detection line 16 is a line which connects to the voltage detecting circuit 3 to the auxiliary ground point 8B, which is the node between the resistor element 19 and the positive-side battery block 1A. The voltage drop of the resistor element 19 can be detected through the resistor element voltage detection line 16. This means that the voltage drop of the resistor element 19 can be detected if the resistor element voltage detection line 16 is disconnected. Disconnection of the resistor element voltage detection line 16 can be detected by switching the detection switches of the second switch block 12B ON/OFF with the resistor element switch 13 being turned ON.

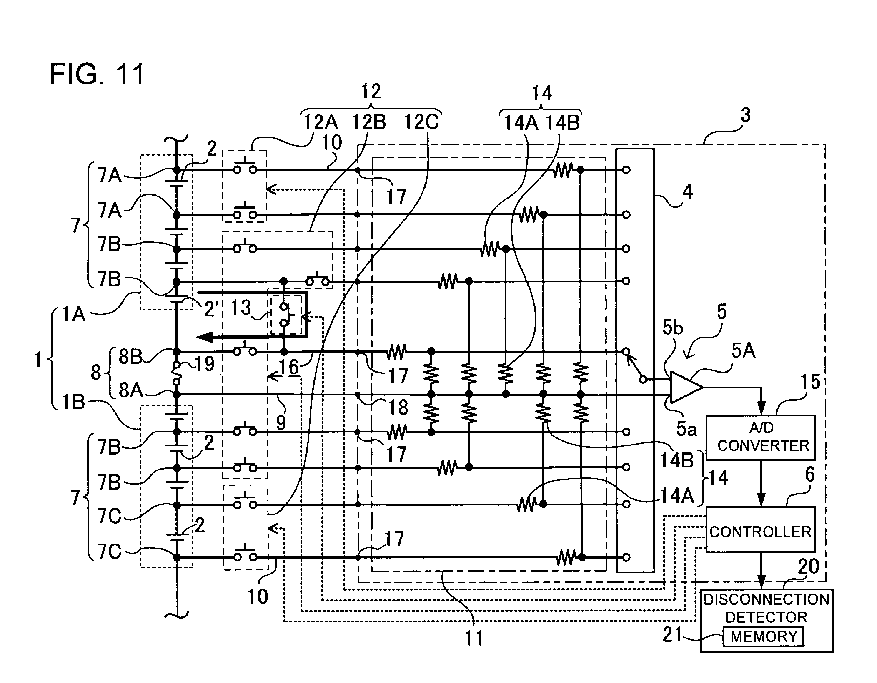

Fig. 10 shows the power supply device with the resistor element switch 13 and the detection switches of the second switch block 12B being ON and OFF, respectively, in the case where the resistor element voltage detection line 16 is not disconnected. The voltage detecting circuit 3 detects the voltage of the node 7 connected to the resistor element switch 13, which is the one node in the positive-side battery block 1A, via the resistor element voltage detection line 16. Then, as shown in Fig. 11, after the second switch block 12B is turned from OFF to ON with the resistor element switch 13 being held ON, the node 7 connected to the resistor element switch 13 is connected to the resistor element voltage detection line 16 through the resistor element switch 13 and one corresponding detection switch of the second switch block 12B. One battery module 2' on the negative side in the positive-side battery block 1A is short-circuited through the resistor element switch 13 and one corresponding detection switch of the second switch block 12B so that the voltage of the resistor element voltage detection line 16 decreases which will be detected by the voltage detecting circuit 3. Accordingly, in the case where the resistor element voltage detection line 16 is not disconnected, when the detection switches of the second switch block 12B are turned from OFF to ON, the voltage detecting circuit 3 detects that the voltage of the resistor element voltage detection line 16 decreases. In order to limit a large amount of short-circuit current that will flow through the battery module 2' on the negative side when the resistor element switch 13 and the second switch block 12B are turned ON, a short-circuit current limiting resistor (not shown) with small electrical resistance is connected to a closed circuit of the battery module 2' on the negative side, the resistor element switch 13, and the one corresponding detection switch of the second switch block 12B.

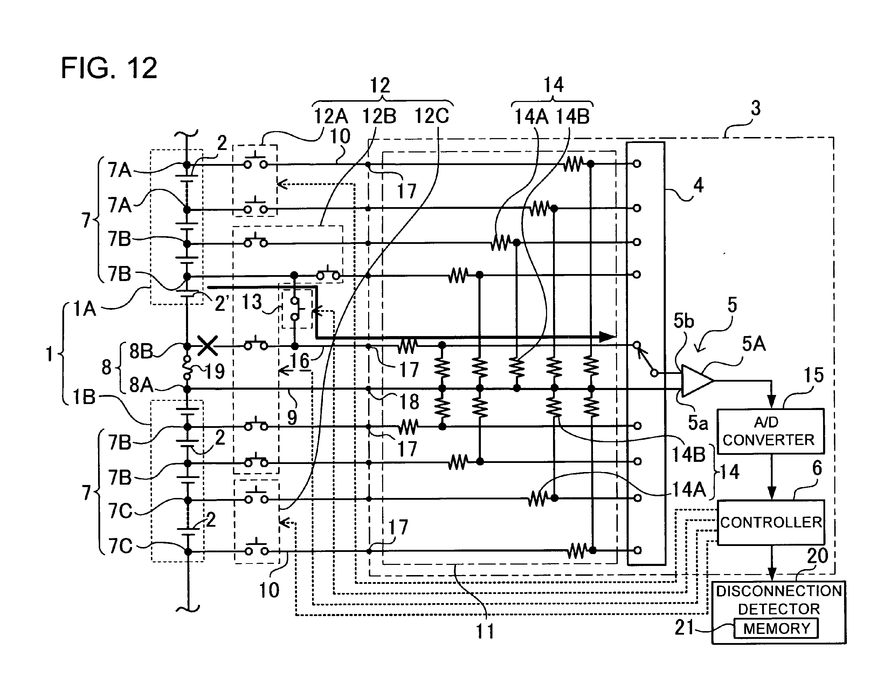

Fig. 12 shows the power supply device with the resistor element voltage detection line 16 being disconnected between the auxiliary ground point 8B and the one corresponding detection switch of the second switch block 12B. In the this disconnection case, even if both the resistor element switch 13 and the second switch block 12B are turned ON, the battery module 2' on the negative side in the positive-side battery block 1A is not short-circuited. For this reason, the voltage detecting circuit 3 detects the voltage at the node 7 connected to the resistor element switch 13. In other words, in the case where the resistor element voltage detection line is disconnected, even when the detection switches of the second switch block 12B are turned from OFF to ON with the resistor element switch 13 being turned ON, the voltage of the resistor element voltage detection line 16 does not change to be detected by the voltage detecting circuit 3. Accordingly, when the detection switches of the second switch block 12B are turned from OFF to ON with the resistor element switch 13 being turned ON, it is determined that the resistor element voltage detection line 13 is not disconnected if the voltage detecting circuit 3 detects that the voltage of the resistor element voltage detection line decreases, while it is determined that the resistor element voltage detection line 13 is disconnected if the voltage detecting circuit 3 does not detects that the voltage of the resistor element voltage detection line decreases.

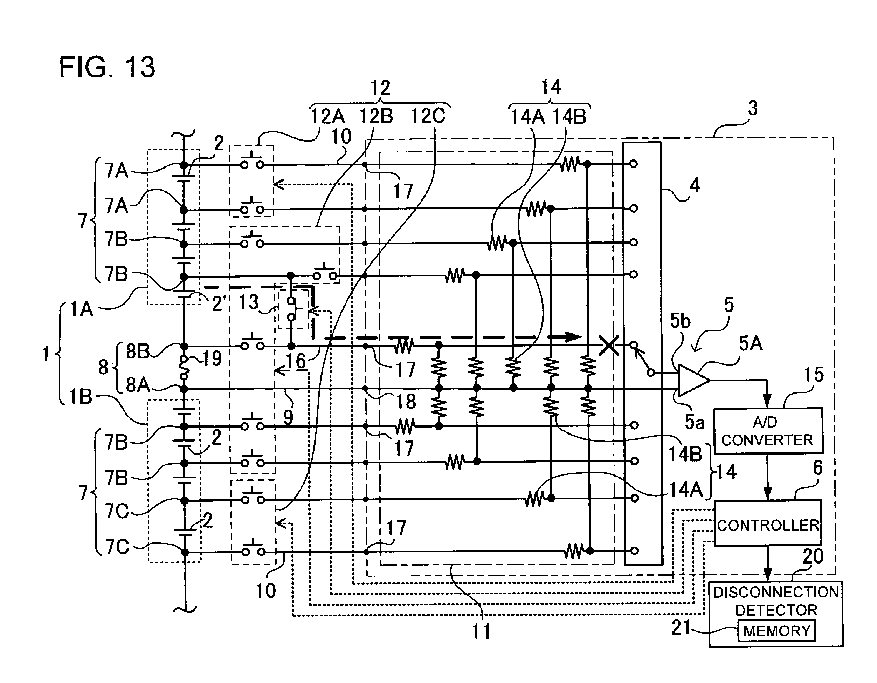

Also, the resistor element voltage detection line 16 may be disconnected between the one corresponding detection switch of the second switch block 12B and the voltage detecting circuit 3, as shown in Fig. 13. In this disconnection case, the voltage detecting circuit 3 cannot detect the voltage at the node 7 connected to the resistor element switch 13. Accordingly, even if the resistor element switch 13 and the one corresponding detection switch of the second switch block 12B are turned ON/OFF, the voltages detected by the voltage detecting circuit 3 do not change. For this reason, when the detection switches of the second switch block 12B are turned from OFF to ON with the resistor element switch 13 being turned ON, it is determined that the resistor element voltage detection line 13 is disconnected if the voltage detecting circuit 3 detects that the voltage of the resistor element voltage detection line does not change. ,

In the power supply device shown in Figs. 3 to 13, the detection switches 12 and the resistor element switch 13 are turned ON/OFF as shown in the following Table 1 so that disconnection of the ground line 9, the resistor element 19 and the resistor element voltage detection line 16 is detected in standby time based on the detection voltages detected by the voltage detecting circuit 3. In the following example, the detection switches 12 and the resistor element switch 13 are turned from OFF to ON so that disconnection of the ground line 9, the resistor element 19 and the resistor element voltage detection line 16 is detected in standby time based on the change of detection voltage detected by the voltage detecting circuit 3. It is noted that the detection switches 12 and the resistor element switch 13 may be turned from ON to OFF so that disconnection can be detected based on the change of detection voltage.

**TABLE 1**

| | Status 1 | Status 2 | Status 3 | Status 4 | Status 5 |
|---|---|---|---|---|---|
| 1 st SW Block | OFF | OFF | OFF | ON | ON |
| 2nd SW Block | OFF | OFF | ON (Data 3) | ON (Data 6) | ON |
| 3rd SW Block | ON (Data 1) | ON | ON (Data 4) | ON (Data 7) | ON |
| Fuse SW | OFF | ON (Data 2) | ON (Data 5) | OFF | OFF |

### [Status 1]

In Status 1, only the third switch block 12C is turned ON, while the other switches (i.e., the first and second switch blocks 12A and 12B, and the resistor element switch 13) are turned OFF. In this status, the voltage detecting circuit 3 detects the voltages at the nodes 7 connected to the detection switches of the third switch block 12C. The detection voltages are detected as Data 1.

### [Status 2]

The third switch block 12C and the resistor element switch 13 are turned ON, while the other switches (i.e., the first and second switch blocks 12A and 12B) are turned OFF. In this status, the voltage detecting circuit 3 detects the voltage of the resistor element voltage detection line 16. The detection voltage is detected as Data 2.

### [Status 3]

The second and third switch blocks 12B and 12C, and the resistor element switch 13 are turned ON, while only the first switch block 12A is turned OFF. In this status, the voltage detecting circuit 3 detects the voltages at the nodes 7 connected to the detection switches of the second switch block 12B, the voltages at the nodes 7 connected to the detection switches of the third switch block 12C, and the voltage of the resistor element voltage detection line 16.
In this case, the voltages at the nodes 7 connected to the detection switches of the second switch block 12B are detected as Data 3, the voltages at the nodes 7 connected to the detection switches of the third switch block 12C are detected as Data 4, and the voltage of the resistor element voltage detection line 16 is detected as Data 5.

### [Status 4]

Only the resistor element switch 13 is turned to OFF, while the other the detection switches 12 (i.e., the first, second and third switch blocks 12A, 12B and 12C) are turned ON. In this status, the voltage detecting circuit 3 detects the voltages at the nodes 7 connected to the detection switches of the second switch block 12B, and the voltages at the nodes 7 connected to the detection switches of the third switch block 12C.
In this case, the voltages at the nodes 7 connected to the detection switches of the second switch block 12B are detected as Data 6, and the voltages at the nodes 7 connected to the detection switches of the third switch block 12C are detected as Data 7.

### [Status 5]

After that, the resistor element switch 13 is turned OFF, while the first, second and third switch blocks 12A, 12B and 12C are turned ON so that the voltages of all of the nodes 7 are detected. Thus, the voltages of the battery modules 2 are detected based on the detected voltages.

Disconnection of the ground line 9, the resistor element 19 and the resistor element voltage detection line 16 is detected in standby time based on Data 1 to 7 obtained in the detection when the switches are switched as discussed above.

### [Disconnection Detection of Ground Line in Standby Time]

Disconnection of the ground line 9 is detected based on whether the voltage change of Data 4 with respect to Data 1 exceeds a predetermined value. If the voltage change exceeds the predetermined value, it is determined that the ground line 9 is disconnected. On the other hand, if the voltage change does not exceed the predetermined value, it is determined that the ground line 9 is not disconnected.
Alternatively, disconnection of the ground line can be detected based on whether the voltage change of Data 7 with respect to Data 4 exceeds a predetermined value. In this case, if the voltage change exceeds a predetermined value, it is determined that the ground line 9 is disconnected. On the other hand, if the voltage change does not exceed the predetermined value, it is determined that the ground line 9 is not disconnected.

### [Disconnection Detection of Resistor Element in Standby Time]

If any node on the positive side with respect to the resistor element 19 has a voltage lower than a predetermined negative voltage in Data 3 or 6, it is determined that the resistor element 19 is disconnected. If no voltage lower than a predetermined negative voltage is included in Data 3 or 6, it is determined that the resistor element 19 is not disconnected.

### [Disconnection Detection of Resistor Element Voltage Detection Line in Standby Time]

If the decrease amount of the voltage change of Data 5 with respect to Data 2 is smaller than a predetermined voltage value, it is determined that disconnection of the resistor element voltage detection line 16 is disconnected. On the other hand, if the decrease amount of the voltage change of Data 5 with respect to Data 2 is not smaller than the predetermined voltage value, it is determined that the resistor element voltage detection line 16 is not disconnected.

The vehicle power supply device shown in Figs. 3 to 14 includes the disconnection detecting circuit 20, which detects disconnection of the ground line 9 also in vehicle traveling. The disconnection detecting circuit 20 detects disconnection of the ground line 9 based on a vehicle traveling voltage. The vehicle traveling voltage as the base of disconnection detection of the ground line 9 is a voltage of the auxiliary ground point 8B detected by the voltage detecting circuit 3 with respect to the reference ground point 8A in vehicle traveling. The disconnection detecting circuit 20 compares the vehicle traveling voltage with a reference voltage of the auxiliary ground point 8B with respect to the reference ground point 8A not in vehicle traveling, i.e. in standby time. The disconnection detecting circuit 20 determines that the ground line 9 is disconnected if the vehicle traveling voltage with respect to the reference voltage falls out of a predetermined voltage range. The disconnection detecting circuit 20 determines that the ground line 9 is not disconnected if the vehicle traveling voltage with respect to the reference voltage falls within the predetermined voltage range.

The disconnection detecting circuit 20 detects the resistor element voltage in standby time, which is not in vehicle traveling, by using the voltage detecting circuit 3, and set the reference voltage at the detected resistor element voltage. It is noted that the disconnection detecting circuit 20 can include a memory 21 that stores the resistor element voltage not in the vehicle traveling, and can set the reference voltage at the resistor element voltage stored in the memory 21. The resistor element voltage not in the vehicle traveling is previously stored in the memory 21.

The voltage of the auxiliary ground point 8B in vehicle traveling with respect to the ground line 9 (i.e., the vehicle traveling voltage) varies. The reason is that, in the case where the ground line 9 is not disconnected, the vehicle traveling voltage detected by the voltage detecting circuit 3 corresponds to the voltage between the both ends of the resistor element 19. The vehicle traveling voltage corresponds to the product of the electrical resistance of the resistor element 19 and current flowing through the driving battery 1. The current flowing through the driving battery 1 varies depending on the vehicle traveling conditions. If the current flowing through the driving battery 1 is large, the vehicle traveling voltage is also large. For example, in the case where the electrical resistance of the resistor element 19 is 50 mΩ, and discharging current and charging current of the driving battery 1 vary within ranges of 0 to 200 A and 0 to 50 A, respectively, the vehicle traveling voltage varies within a range of -2.5 to 10 V. In this case, the predetermined voltage range for detection of ground line 9 disconnection is set at a range wider than the range of -2.5 to 10 V, e.g., at a range of -3 to 12 V. Thus, the predetermined voltage range for detection of ground line 9 disconnection is set at a range wider than the voltage range where the vehicle traveling voltage varies when the ground line 9 is not disconnected. In addition, the voltage dividing resistor circuit 11 is asymmetrically constructed so that the vehicle traveling voltage will be larger than the predetermined voltage range if the ground line 9 is disconnected.

The voltage detecting circuit 3 detects the vehicle traveling voltage with the voltage at the reference ground point 8A being set at the assumed ground potential in the case where the ground line 9 is not disconnected. Accordingly, the vehicle traveling voltage in this case corresponds to the voltage between the both ends of the resistor element 19. If the ground line 9 is disconnected, the assumed ground potential is deviated by the asymmetrical voltage dividing resistor circuit 11. Accordingly, the vehicle traveling voltage is provided to the voltage detecting circuit 3 with the assumed ground potential being deviated. In the case where the voltage detecting circuit 3 includes a differential amplifier as the voltage detecting portion 5, since the voltage detecting circuit 3 detects an input voltage with respect to the assumed ground potential, if the ground line 9 is disconnected, the vehicle traveling voltage is detected as a voltage substantially deviated from the case where the ground line 9 is not disconnected, in other words, the voltage detecting circuit 3 will detect a voltage out of the predetermined voltage range as the vehicle traveling voltage. The reason is that the voltage dividing resistor circuit 11 is asymmetrically constructed so that the detected vehicle traveling voltage falls out of the predetermined voltage range when all of the detection switches 12 are turned ON if the ground line 9 is disconnected.

If it is determined that the ground line 9 and the resistor element voltage detection line 16 are disconnected as discussed above, the charging/discharging output of the driving battery 1 is limited in the vehicle including the power supply device.

In order to that the nodes 7 and the auxiliary ground point 8B can be switched one after another to selectively detect the voltages at the nodes 7 and the auxiliary ground point 8B, the multiplexer 4 is connected to the input side of the voltage detecting portion 5. Thus, the multiplexer 4 provides the voltage at the nodes 7 corresponding to the battery modules 2 and the auxiliary ground point 8B to the voltage detecting portion 5 by switching the nodes 7 and the auxiliary ground point 8B one after another. When the voltages of the battery modules 2 are selectively detected, the multiplexer 4 of the voltage detecting circuit 3 provides the voltages at all of the nodes 7 corresponding to the battery modules 2 and the auxiliary ground point 8B to the voltage detecting portion 5 one after another. Thus, the multiplexer 4 is connected to the input side of the voltage detecting portion 5, and switches the nodes 7 corresponding to the battery modules 2 and the auxiliary ground point 8B one after another for detection of the voltages of the battery modules 2.

The voltage detecting circuit 5 detects the voltages at the nodes 7 and the auxiliary ground point 8B with respect to the reference ground point 8A, and detects the voltages of the battery modules 2. The reference ground point 8A is a midpoint in the serially-connected battery modules 2. The divided parts on the positive and negative sides divided by the reference ground point 8A include the substantially same number of battery modules 2 as each other. The illustrated voltage detecting portion 5 is a differential amplifier 5A. A reference input side terminal 5a as one input terminal of the differential amplifier 5A is connected to the reference ground point 8A. A voltage input side terminal 5b as the other input terminal of the differential amplifier 5A is selectively connected to the nodes 7 corresponding to the battery modules 2 and the auxiliary ground point 8B through the multiplexer 4. Thus, the voltages at the nodes 7 and the auxiliary ground point 8B are detected with respect to the reference ground point 8A. However, the voltage detecting portion is not necessarily composed of the differential amplifier. The reason is that the reference ground point can be connected to a reference input side terminal as the negative-side input terminal of an amplifier while the nodes corresponding to the battery modules and the auxiliary ground point can be connected to a voltage input side terminal as the positive-side input terminal of the amplifier through the multiplexer so that the voltages at the nodes and the auxiliary ground point are detected with respect to the reference ground point.

The voltage of one battery module 2 is detected based on the voltage difference between the nodes 7 to which the both ends of the battery module 2 are connected. For example, in Fig. 3, the voltage value E2 of one battery module M2 is obtained by V2 - V1, and the voltage E3 of one battery module M3 is obtained V3 - V2. When the voltage of the battery module 2' is detected which is connected at the point closest to the negative side in the positive-side battery block 1A, a resistor element voltage Eh between the both ends of the resistor element 19 is detected so that the voltage at the node 7 corresponding to the battery module 2' is corrected based on the resistor element voltage Eh. If the power supply device does not detect the voltage decrease of the resistor element 19, the voltage of the negative-side battery module 2' is detected by V1 - V0. Accordingly, the voltage is not accurate since the voltage decrease of the resistor element 19 is added to this voltage. Contrary to this, in the power supply device according to the present invention, the resistor element voltage Eh as the voltage decrease of the resistor element 19 is detected so that the voltage of the negative-side battery module 2' is corrected from V1 - V0 based on the resistor element voltage Eh. Thus, the voltage E1 of the battery module M1 as the negative side battery module 2' can be accurately detected. The resistor element voltage Eh between the both ends of the resistor element 19 is the voltage at the auxiliary ground point 8B with respect to the reference ground point 8A, and is detected by Vh - V0. That is, the voltage E1 of the battery module M1 is accurately detected by V1 - Vh. As discussed above, the control circuit 6 calculates the detection of the voltages of the battery module and the resistor element based on the voltages at the nodes 7 and the auxiliary ground point 8B.

In the illustrated voltage detecting circuit 3, the voltage detecting portion 5 is connected to the output side of the multiplexer 4, while the A/D converter 15 is connected to the output side of the voltage detecting portion 5. In the voltage detecting circuit 3, the multiplexer 4 selectively connects the nodes 7 and the auxiliary ground point 8B one after another to the voltage detecting portion 5. Thus, the voltage detecting portion 5 detects the voltages at the nodes 7 and the auxiliary ground point 8B one after another. The outputs of the voltage detecting portion 5 are converted into digital signals by the A/D converter 15, and are then provided to the control circuit 6. The control circuit 6 calculates the voltage signals, which is provided as the digital signals, and detects the voltages of the battery modules 2.

The voltage detecting circuit 3 detects the voltages at the nodes in the driving battery 1 and the auxiliary ground point 8B with respect to the reference ground point 8A. That is, the reference ground point 8A is used as a reference point when the voltages at the nodes and the auxiliary ground point 8B are detected. For this reason, if the voltage of the reference ground point 8A is improper, the voltages of all of the nodes 7 and the auxiliary ground point 8B cannot be properly detected. Accordingly, the voltages of the battery modules 2 cannot be accurately detected. The reference ground point 8A in the driving battery 1 is connected to the voltage detecting circuit 3 via the ground line 9. The ground line 9 connects the input side of the voltage detecting circuit 3 to the reference ground point 8A in the driving battery 1 through the connecting cords. Also, the connecting cords are connected to the reference ground point 8A in the driving battery 1 through connectors or terminals. In the case where one end of a connecting cord is connected to the reference ground point 8A, the other end of this connecting cord is connected by soldering to a circuit board on which electronic components are mounted to realize the voltage detecting circuit 3, or is connected to the input side of the voltage detecting circuit 3 through connectors. Poor contact is likely to occur in connection part between connecting cord, and connector, terminal, or the like. If poor contact occurs on the ground line 9, the voltage at the reference ground point 8A varies which is provided to the voltage detecting circuit 3.

Disconnection of the ground line 9 is detected as discussed above. If it is determined that the ground line 9 is disconnected, the vehicle can be powered by the power supply device with the charging/discharging output of the driving battery 1 being limited for battery module 2 protection. Also, if the ground line 9 is disconnected, when the ignition switch is turned OFF so that the vehicle is not in use, the power supply device does not power the electric motor, alternatively the vehicle is brought into a disabled state.

### (Power Storage Type Power Supply Device)

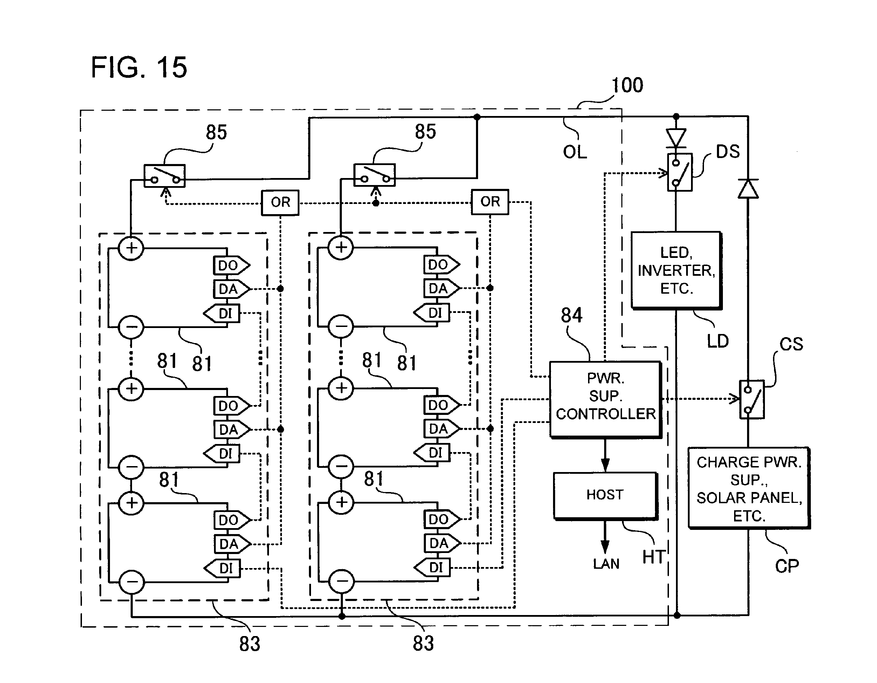

The power supply device can be used not only as power supply of mobile unit such as vehicle but also as stationary power storage. For example, examples of stationary power storage devices can be provided by an electric power system for home use or plant use that is charged with solar electric power or with midnight electric power and is discharged when necessary, a power supply for street lights that is charged with solar electric power during the daytime and is discharged during the nighttime, or a backup power supply for signal lights that drives signal lights in the event of a power failure. Fig. 15 shows a circuit diagram according to this embodiment. This illustrated power supply device 100 includes battery units 83 each of which includes a plurality of battery blocks 81 that are serially connected to each other. In each of battery blocks 81, a plurality of battery cells are connected to each other in serial and/or in parallel. The battery blocks 81 are controlled by a power supply controller 84. In this power supply device 100, after the battery units 83 are charged by a charging power supply CP, the power supply device 100 drives a load LD. The power supply device 100 has a charging mode and a discharging mode. The Load LD and the charging power supply CP are connected to the power supply device 100 through a discharging switch DS and a charging switch CS, respectively. The discharging switch DS and the charging operation switch CS are turned ON/OFF by the power supply controller 84 of the power supply device 100. In the charging mode, the power supply controller 84 turns charging operation switch CS ON, and turns the discharging switch DS OFF so that the power supply device 100 can be charged by the charging power supply CP. When the charging operation is completed so that the battery units are fully charged or when the battery units are charged to a capacity not lower than a predetermined value, if the load LD requests electric power, the power supply controller 84 turns the charging operation switch CS OFF, and turns the discharging switch DS ON. Thus, operation is switched from the charging mode to the discharging mode so that the power supply device 100 can be discharged to supply power to the load LD. In addition, if necessary, the charging operation switch CS may be turned ON, while the discharging switch DS may be turned ON so that the load LD can be supplied with electric power while the power supply device 100 can be charged.

The load LD driven by the power supply device 100 is connected to the power supply device 100 through the discharging switch DS. In the discharging mode of the power supply device 100, the power supply controller 84 turns the discharging switch DS ON so that the power supply device 100 is connected to the load LD. Thus, the load LD is driven with electric power from the power supply device 100. Switching elements such as FET can be used as the discharging switch DS. The discharging switch DS is turned ON/OFF by the power supply controller 84 of the power supply device 100. The power supply controller 84 includes a communication interface for communicating with an external device. In the power supply device according to the embodiment shown in Fig. 15, the power supply controller is connected to a host device HT based on existing communications protocols such as UART and RS-232C. Also, the power supply device may include a user interface that allows users to operate the electric power system if necessary.
It should be apparent to those with an ordinary skill in the art that while various preferred embodiments of the invention have been shown and described, it is contemplated that the invention is not limited to the particular embodiments disclosed, which are deemed to be merely illustrative of the inventive concepts and should not be interpreted as limiting the scope of the invention, and which are suitable for all modifications and changes falling within the scope of the invention as defined in the appended claims.

## Claims

1. A power supply device comprising:
a load-driving battery (1) including positive-side and negative-side battery blocks (1A, 1 B) that are serially connected to each other through a resistor element (19);
a voltage detecting circuit (3) for detecting the voltages of battery modules (2) that are serially connected to each other and compose the load-driving battery (1);
a ground line (9) connecting one of the input terminals of said voltage detecting circuit (3) to a reference ground point (8A) of the load-driving battery (1);
an asymmetric voltage dividing resistor circuit (11) connected to the input terminals of said voltage detecting circuit (3), the asymmetric voltage dividing resistor circuit being asymmetrically constructed with respect to the reference ground point (8A); and
a disconnection detecting circuit (20) for detecting disconnection of said ground line (9),
**characterized in that**
a node between one end of said resistor element (19) and one of the battery blocks of said load-driving battery (1) serves as the reference ground point (8A), and a node between the other end of said resistor element (19) and the other of the battery blocks of said load-driving battery (1) serves as an auxiliary ground point (8B), wherein
said voltage detecting circuit (3) detects the voltage of the auxiliary ground point (8B) with respect to the reference ground point (8A) with the auxiliary ground point (8B) being connected to said voltage detecting circuit (3) through the voltage dividing resistor circuit (11), and wherein
said voltage detecting circuit (3) detects the voltage of the auxiliary ground point (8B) as a load-driving voltage with respect to the reference ground point (8A) in a load driven state, and said disconnection detecting circuit (20) compares the detected load-driving voltage with a reference voltage of the auxiliary ground point (8B) with respect to the reference ground point (8A) not in the load driven state and determines that the ground line (9) is disconnected in the load driven state if the deviation of the detected load-driving voltage from reference voltage falls out of a predetermined voltage range.

2. The power supply device according to claim 1, wherein the resistor element (19) is a fuse (19A), a current detecting resistor, or a series circuit composed of fuse and current detecting resistor.

3. The power supply device according to claim 1 or 2, wherein the reference voltage is obtained by detecting a resistor element voltage not in the load driven state by said voltage detecting circuit (3), or a resistor element voltage not in the load driven state is previously stored as the reference voltage in the memory (21).

4. The power supply device according to claim 3, wherein the reference voltage is obtained by detecting the resistor element voltage by said voltage detecting circuit (3) in standby time where the load-driving battery (1) is not charged/discharged after an actuation switch of a load is turned ON.

5. The power supply device according to any of claims 1 to 4, wherein said voltage detecting circuit (3) is a circuit for detecting the voltages of battery modules (2), which compose the load-driving battery (1).

6. The power supply device according to claim 1 further comprising
a resistor element voltage detection line (16) that has one end connected to said auxiliary ground point (8B), and other end connected to corresponding one (17) of the input terminals of the current detecting circuit 3, and
a detection switch (12) that is connected at a point on the resistor element voltage detection line (16), wherein
the voltage detecting circuit (3) is provided via the resistor element voltage detection line (16) with the voltage of the auxiliary ground point (8B) with respect to the reference ground point (8A), and detects the voltage drop of said resistor element (19).

7. The power supply device according to claim 6, wherein said resistor element voltage detection line (16), which is connected to said auxiliary ground point (8B), is connected to a node (7) as one side of one of the battery modules in the other of the battery blocks through a resistor element switch (13) that can be turned ON/OFF, wherein
the voltage detecting circuit (3) is connected to one end of the resistor element switch (13), which is connected to said resistor element voltage detection line (16), and the other end of the resistor element switch (13) is directly connected to the node (7) as one side of one of the battery modules the other side of which is connected to the auxiliary ground point 8B, wherein
disconnection of said resistor element voltage detection line (16) is detected by controlling ON/OFF switching of the detection switch (12) and the resistor element switch (13).

8. The power supply device according to any of claims 1 to 7, wherein said power supply device is a vehicle power supply device.

9. The power supply device according to claim 8, wherein the reference voltage is obtained by detecting a resistor element voltage not in vehicle traveling by said voltage detecting circuit (3), or a resistor element voltage not in vehicle traveling is previously stored as the reference voltage in the memory (21).

10. The power supply device according to claim 9, wherein the reference voltage is obtained by detecting the resistor element voltage by said voltage detecting circuit (3) in standby time where the load-driving battery (1) is not charged/discharged after an ignition switch as vehicle main switch is turned ON.

11. The power supply device according to any of claims 8 to 10, wherein said voltage detecting circuit (3) is a circuit for detecting the voltages of battery modules (2), which compose the driving battery (1).

12. The power supply device according to any of claims 1 to 7, wherein said power supply device is a power storage type power supply device.
